# EUROPEAN PATENT SPECIFICATION

(11) **EP 2 369 028 B1**
(45) Date of publication and mention of the grant of the patent: **13.03.2013**
(21) Application number: 11156311.0
(22) Date of filing: 28.02.2011
(51) Int. Cl.: C23C 8/24, C23C 8/36, C23C 14/48, H01J 37/32

(54) **Method for nitriding metal alloys and device for carrying out said method**
Verfahren und Vorrichtung zum Nitrieren metalische Legierungen
Procéde de nitruration des alliages métalliques et dispositif pour sa réalisation

(30) Priority: 01.03.2010 ES 201000249
(43) Date of publication of application: 28.09.2011
(73) Proprietor: Asociacion de la Industria Navarra (AIN), 31191 Cordovilla (Navarra ) (ES)
(72) Inventor: García Fuentes, Gonzalo, 31191 Cordovilla (Navarra) (ES); García Lorente, Jose Antonio, 31191 Cordovilla (Navarra) (ES); Rodriguez Trías, Rafael, 31191 Cordovilla (Navarra) (ES)
(74) Representative: Hubert, Philippe

(56) References cited:
- JP-A- 2007 314 845
- US-A1- 2004 213 891
- WEI RONGHUA ET AL: "High intentsity plasma ion nitriding of Aermet 100 martensitic steel", PLASMA PROCESSES AND POLYMERS 2007 WILEY-VCH VERLAG DEU,, vol. 4, no. SUPPL.1, 30 May 2007 (2007-05-30), pages S700-S706, XP002635245,

## Description

### Field of the Art

The present invention relates to thermochemical treatments carried out to improve the mechanical properties of metal alloys, proposing to that end a device and a method for nitriding metal alloys carried out by means of the ion nitriding technique with a plasma activated by an electric arc process in high vacuum conditions, whereby obtaining nitrided surfaces of between 7-15 microns thick in times of less than 120 minutes. This method is preferably applied for cobalt-chromium-molybdenum (CoCrMo) alloys, though it could also be valid for other metal alloys, such as stainless steels, precipitation hardening steels, tool steels, of Inconel or Hastelloy alloys, for example.

### State of the Art

Cobalt-chromium-molybdenum (CoCrMo) alloys are some of the most widely used alloys for orthopedic implants, such as hip, elbow or knee joints. Parts of this type require a surface hardening process in order to withstand wear, while their interior must present certain plasticity to withstand impacts.

To this respect there are several thermochemical techniques for providing metal alloys with surface hardness which are based on changing the chemical composition of the part by means of reactive gas diffusion. The most widely used techniques for this purpose include carburization, which incorporates carbon as a reactive gas, carbonitriding which incorporates carbon and nitrogen, and nitriding which incorporates nitrogen.

Ion nitriding, also referred to as plasma nitriding, which is based on using an electric current to ionize the particles of the nitrogen gas forming the plasma, is known within the nitriding technique. The process is performed in a reactor where reactive gases for nitriding are introduced. The parts to be treated are electrically isolated in a chamber of the reactor and connected to a direct current electric supply thereof, so the parts are established at a negative potential forming a cathode (-) and the chamber of the reactor at a positive potential forming an anode (+). The electrically positive ions in the plasma are accelerated and directed towards the negative terminal, forming the nitrided layer.

Conventional ion nitriding processes use a mix of nitrogen with a combination of other gases, including hydrogen. These processes are carried out at high pressures and therefore need hydrogen to prevent oxidation of the steel. However, in the case of cabalt-chromium-molybdenum, hydrogen slows down the formation of the coating and its high flammability makes it an extremely dangerous compound to use.

Ion implantation processes are also known in which an ion beam is projected from a coating source against the part to be treated, these ions penetrating the part to form the coating; this technique obtains high-quality coatings with high wear resistance, however it involves high energy consumption, does not allow coating several parts at a time, but rather only sequentially, and the surfaces concealed from the incidence of the ion beam cannot be treated, whereas in the case of ion nitriding the plasma completely envelopes the parts, all the surfaces thereof being treated.

In these part surface hardening techniques it has been found that increasing the process temperature increases the depth of the coating and further accelerates the treatment time; nevertheless, high temperatures can cause unwanted effects on the parts to be treated, such as the loss of anticorrosive properties as an example.

It is therefore necessary to provide a process for nitriding metal alloys, especially cobalt-chromium-molybdenum metal alloys, which is carried out in high vacuum (low pressure) conditions, whereby preventing oxidation of the part to be coated and, therefore, the need to use hydrogen as a reactive gas, and which can also be carried out at a low temperature, obtaining optimal coating thickness in a short time.

US2004/0213891 A1 teaches introducing nitrogen into a vacuum chamber so that the pressure in the vacuum chamber is about 0.01 to about 10 milli-Torr; generating electrons within the vacuum chamber to form positively charged nitrogen ions; providing a negative bias to the worktable so that the positively charged nitrogen ions contact biomedical devices under conditions such that a nitride layer forms.

According to JP 2007314845, a nitriding treatment apparatus passes an electric current through a plasma focusing coil to make the plasma focusing coil generate a magnetic field so as to lead nitrogen ions and electrons to a specimen support and further applies a bias voltage which alternately switches between a positive voltage and a negative voltage to the specimen support, such that a nitride film is formed in a state of being kept activated.

For nitriding a martensitic steel by using HIPIN process, WEI RONGHUA ET AL: "High intensity plasma ion nitriding of Aermet 100 martensitic steel", PLASMA PROCESSES AND POLYMERS 2007 WILEY-VCH VERLAG DEU, vol. 4, no. SUPPL. 1, 30 May 2007 (2007-05-30), pages S700-S706 teaches how the parameters of the process (temperatures, pressures, current density, voltages, etc.) can be adjusted for obtaining higher nitrogen case depth.

### Object of the Invention

The invention is defined in the claims.

According to the present invention a method of claim 1 for nitriding metal alloys is proposed which is carried out by means of the ion nitriding technique with plasma activated by an electric arc process in high vacuum conditions, obtaining nitrided surfaces of between 7-15 microns thick in times of less than 120 minutes.

An object of the present invention is to obtain high density plasma activated by means of the presence of an electric discharge inside a reactor, whereby achieving that the molecules of the gases forming the plasma go to high energy states, favoring the rate of the chemical reaction and allowing working at temperatures of less than 450°C.

Another object of the present invention is to obtain a method for nitriding metal alloys, preferably cobalt-chromium-molybdenum (CoCrMo) metal alloys, which is carried out in high vacuum conditions, i.e., at very low pressures, of the order of microbars, whereby preventing the contamination of the coating and the need to use hydrogen in the nitriding process.

A method for nitriding metal alloys of claim 1 comprises at least the following steps:
- Cleaning the parts to be nitrided and placing them on a support inside a reactor from which the air is extracted to form a high vacuum with a pressure not greater than 5x10⁻⁶ mbars.
- Performing prior thermal heating of the reactor by means of switching on a heat source for at least 15 minutes until reaching a temperature of not more than 200°C.
- Heating the parts to be nitrided to a temperature comprised between 300°C and 600°C. This heating is done by means of ion bombardment by means of injecting a noble gas, preferably argon, wherein the noble gas is introduced until reaching a pressure of between 1x10⁻² and 1x10⁻³ mbars; at least one electric arc discharge unit is activated with a current of between 70 and 90 amperes, an electron collector is polarized with a direct voltage of between +10 and +50 volts and the support for the parts to be nitrided is polarized with a direct voltage of between -400 and -800 volts.
- Activating all the electric arc discharge units between a current of 50 and 90 amperes, preferably 70 amperes; and polarizing the support for the parts at a pulsed direct voltage between -300 and -700 volts, preferably between -400 and -600 volts pulsed at 20-30 KHz.
- Injecting nitrogen into the reactor until the proportion between the noble gas and nitrogen is at least 10% nitrogen and the pressure inside the reactor is comprised between 1x10 ³ and 8x10⁻³ mbars; whereby obtaining a nitrided layer in the part of up to 15 microns in a time of less than 120 minutes. The proportion between the noble gas and nitrogen is preferably at equal parts of 50/50.

The invention applicant has observed that the density of the plasma is greater in the proximity of the casing of the reactor in which the nitriding process is carried out, i.e., the area of the reactor which is earthed, which causes the concentration of ionized particles per cubic centimeter to increase as said earthed areas are approached.

To that end, the present invention proposes a device for carrying out the method for nitriding metal alloys, said device consisting of an earthed reactor in which the parts to be nitrided are placed on a support established at a pulsed negative potential, the reactor including electric arc discharge units, a heat source for heating the parts and an electron collector electrically insulated from the reactor and established at a positive potential, coils for concentrating the electric field which are earthed, or connected to a negative potential, being arranged around the electron collector. A large amount of ions are thus generated in the proximity of said coils for concentrating the electric field, high density plasma which accelerates the nitriding process being obtained.

### Description of the Drawings

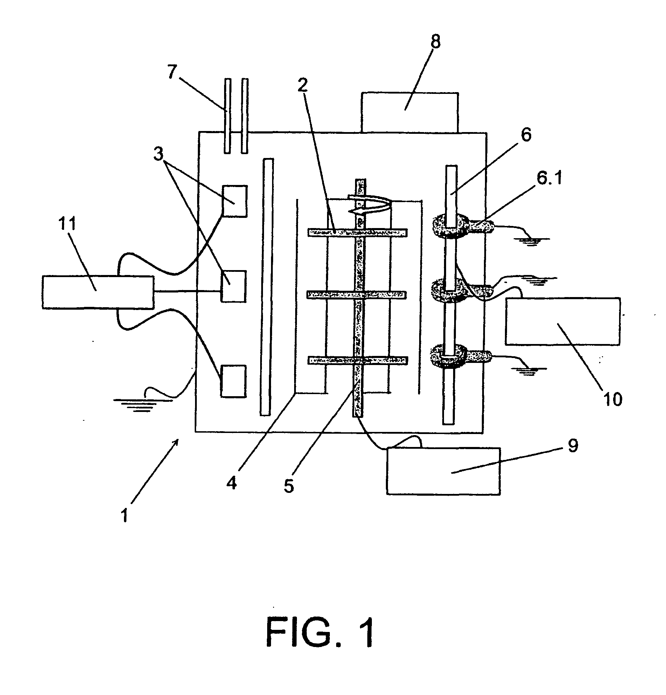

Figure 1 shows a diagram of the reactor in which the method for nitriding object of the invention is carried out.

### Detailed Description of the Invention

Figure 1 shows an earthed reactor (1) in which the process for nitriding parts (2) is carried out, comprising three electric arc discharge units (3), a heat source (4), a support (5) for the parts (2), an electron collector (6) as well as a gas inlet (7) with a mass flow meter and a vacuum system (8).

The support (5) for the parts (2) to be nitrided is connected to a pulsed direct current source (9) which delivers a voltage of between 100-1000 volts with a pulse frequency of 0-40 kHz. The electron collector (6) is connected to a 10-50 volt direct current source (10), and the electric arc discharge units (3) are also connected to a direct current power system (11) (it could also be pulsed direct current), whereas the heat source (4) is connected to another direct current source (not depicted).

With this set-up, as a first step of the method for nitriding of the invention, the parts (2) to be nitrided are previously cleaned, said parts being placed on the support (5) inside the reactor (1); next the air is extracted from the reactor (1) by means of the vacuum system (8) until reaching a residual vacuum with a pressure not greater than 5x10⁻⁶ mbars, whereby preventing the parts (2) from being in contact with the air, which would cause the oxidation of the surface of the parts (2).

Once this high residual vacuum is formed, prior thermal heating is performed by means of the heat source (4) for at least 15 minutes. The temperature of the reactor (1) does not exceed 200°C with this heating.

Then another heating step is performed by means of introducing a noble gas, preferably argon, such that by means of a bombardment with ions of said noble gas lasting for about 10 minutes, plasma is generated which is capable of heating the parts (2) to a temperature of between 300°C and 600°C. To that end the gas is introduced through the inlet (7) until reaching a pressure inside the reactor (1) of between 1x10⁻² mbars and 1x10⁻³ mbars, at least one electric arc discharge unit (3) is activated with a current of between 70 and 90 amperes, the electron collector (6) is polarized by means of the source (10) with a direct voltage of between +10 and +50 volts and the support (5) for the parts (2) is polarized by means of the source (9) with a direct voltage of between -400 and -800 volts. This heating of the parts (2) favors the subsequent nitrogen diffusion for the formation of nitrides, or other phases with a high hardness, in the parts (2).

It has been foreseen that in the specific case of certain metal alloys prone to the oxidation, as is the case of tool steels such as DIN2379, DIN2344, etc., in order to prevent the formation of oxides and improve the quality of the obtained nitrided layer, a certain amount of hydrogen is introduced together with the noble gas, this amount being in any case less than that used in conventional nitriding processes.

After heating the parts (2) and, as a step prior to nitriding, the three electric arc discharge units (3) are activated between a current of 50 and 90 amperes, preferably 70 amperes per electric arc discharge unit (3), and the support (5) for the parts (2) is polarized with a pulsed direct voltage of between -300 and -700 volts, preferably between -400 and -600 volts. The pulse frequency provided by the direct current source (9) is established between 20-30 kHz and the time ratio for which the support (5) is being polarized is comprised between 50% and 90% of the period of the signal of the source (9). Therefore by limiting the time per period for which the source (9) of direct current is polarizing the support (5), it prevents said support (5) from becoming saturated with a positive surface charge.

After this point the injection of nitrogen into the reactor (1) begins until the proportion between the noble gas and the nitrogen is at least 10% nitrogen and the pressure inside the reactor (1) is comprised between 1x10⁻³ and 8x10⁻³ mbars. The proportion between the noble gas and the nitrogen is preferably foreseen to be comprised at equal parts of 50/50.

The nitrogen (N₂) diffusion in the part (2) thus begins, the electrically positive ions of the plasma produced are accelerated and directed towards the negative terminal, in this case the parts (2), whereas the electrons of the plasma are directed towards the positively polarized electron collector. The molecular nitrogen (N₂) is broken down and ionized by means of luminescent electric discharges while the parts (2) are heated. This favors the nitrogen diffusion on the surface of the parts (2) and the formation of nitrides, whereby obtaining a hard and tenacious nitrided layer of the surface of the parts (2).

The plasma thus obtained presents a strong glow, especially in the proximity of the electron collector (6) in which a large amount of ions are generated. A nitrided layer of up to 15 microns thick formed in a time of less than 120 minutes can be obtained by means of the conditions of nitrogen ionization and heating by ion bombardment. After the nitriding process, all the systems are disconnected and the reactor (1) is left to cool until the vacuum can be safely broken, preventing the nitrided layer from oxidizing by the action of contact with the air.

The electron collector (6) of the reactor (1) shown in Figure has coils (6.1) for concentrating the electric field arranged around it which are directly earthed for assembly simplicity, although they could also be connected to a negative potential, without the operation thereof being affected as a result. The electric field is thus increased, a large amount of ions forming a high density plasma, which allows accelerating the nitriding process for nitriding the parts (2), being generated around these coils (6.1).

## Claims

1. A method for nitriding metal alloys, of the type carried out in an earthed reactor (1) having coils (6.1) for concentrating an electric field which are earthed, or connected to a negative potential and arranged around an electron collector electrically insulated from the reactor (1) (6), in which reactor the parts (2) to be nitrided are arranged on a support (5) established at a pulsed negative potential, said reactor (1) including electric arc discharge units (3), a heat source (4), , a gas inlet (7) and a vacuum system (8), **characterized in that** the method comprises at least the hollowing steps:
-Forming a high vacuum in the reactor (1) with a pressure not greater than 5x10-6 mbars.
-Performing prior thermal heating of the reactor (1) by means of the heat source (4) until reaching a temperature of not more than 200°C,
-Heating the parts (2) by means of introducing a noble gas and performing a bombardment in which at least one electric arc discharge unit (3) is activated with a current of between 70 and 90 amperes, the electron collector (6) is polarized with a direct voltage of between +10 and +50 volts and the support (5) is polarized with a direct voltage of between -400 and -800 volts, wherein the parts (2) are heated up to a temperature of between 300°C and 600°C,
- Activating all the electric arc discharge units (3) between a current of 50 and 90 amperes and polarizing the support (5) at a pulsed direct voltage between -300 and -700 volts, and
- Injecting nitrogen into the reactor (1) until the proportion between the noble gas and the nitrogen is at least 10% nitrogen and the pressure inside the reactor (1) is comprised between 1x10⁻³ and 8x10⁻³ mbars.

2. The method for nitriding metal alloys according to claim 1, **characterized in that** in the step of heating the parts (2), the noble gas is introduced until reaching a pressure inside the reactor (1) of between 1x10-2 mbars and 1x10-3 mbars.

3. The method for nitriding metal alloys according to claim 1, **characterized in that** the noble gas used is argon.

4. The method for nitriding metal alloys according to claim 1, **characterized in that** the electric arc discharge units (3) are activated with a current of 70 amperes.

5. The method for nitriding metal alloys according to claim 1, **characterized in that** the support (5) is polarized between -400 and -600 volts pulsed at 20-30 KHz.

6. The method for nitriding metal alloys according to claim 1, **characterized in that** the proportion between the noble gas and the nitrogen that are introduced in the reactor (1) is at equal parts of 50/50.

7. The method for nitriding metal alloys according to claim 1, **characterized in that** hydrogen is introduced together with the noble gas.

8. A device for carrying out the method for nitriding metal alloys of claim 1 consisting of an earthed reactor (1) in which the parts (2) to be nitrided are arranged on a support (5) established at a pulsed negative potential, said reactor (1) including electric arc discharge units (3), a heat source (4), an electron collector (6) electrically insulated from the reactor (1), a gas inlet (7) and a vacuum system (8), **characterized in that** coils (6.1) for concentrating the electric field which are earthed, or connected to a negative potential, are arranged around the electron collector (6).

## Patentansprüche

1. Verfahren zum Nitrieren von Metallegierungen des Typs, der in einem geerdeten Reaktor (1) ausgeführt wird, der Spulen (6.1) zum Konzentrieren eines elektrischen Feldes aufweist, die geerdet oder mit einem Negativpotential verbunden und um eine Auffangelektrode (6), die von dem Reaktor (1) elektrisch isoliert ist, herum angeordnet sind, wobei in dem Reaktor die zu nitrierenden Teile (2) auf einem Träger (5) angeordnet sind, der auf einem pulsierenden Negativpotential errichtet ist, wobei der Reaktor (1) elektrische Bogenentladungseinheiten (3), eine Wärmequelle (4), einen Gaseinlaß (7) und ein Vakuumsystem (8) umfaßt, **dadurch gekennzeichnet, daß** das Verfahren zumindest die folgenden Schritte umfaßt:
- Ausbilden eines Hochvakuums in dem Reaktor (1) mit einem Druck, der nicht mehr als 5x10⁻⁶ mbar beträgt,
- Durchführen einer thermischen Vorwärmung des Reaktors (1) mittels der Wärmequelle (4), bis eine Temperatur von nicht mehr als 200 °C erreicht ist,
- Erwärmen der Teile (2) mittels Einleiten eines Edelgases und Durchführen eines Beschusses, wobei wenigstens eine elektrische Bogenentladungseinheit (3) mit einem Strom von 70 bis 90 Ampere aktiviert wird, die Auffangelektrode (6) mit einer Gleichspannung von +10 bis +50 Volt polarisiert wird und der Träger (5) mit einer Gleichspannung von -400 bis -800 Volt polarisiert wird, wobei die Teile (2) bis auf eine Temperatur von 300 °C bis 600 °C erwärmt werden,
- Aktivieren aller elektrischen Bogenentladungseinheiten (3) mit einem Strom von 50 bis 90 Ampere und Polarisieren des Trägers (5) bei einer pulsierenden Gleichspannung von -300 bis -700 Volt und
- Einspeisen von Stickstoff in den Reaktor (1), bis das Verhältnis zwischen dem Edelgas und dem Stickstoff wenigstens 10 % Stickstoff beträgt und der Druck in dem Reaktor (1) zwischen 1x10⁻³ und 8x10⁻³ mbar liegt.

2. Verfahren zum Nitrieren von Metallegierungen nach Anspruch 1, **dadurch gekennzeichnet, daß** in dem Schritt des Erwärmens der Teile (2) das Edelgas eingeleitet wird, bis ein Druck von 1x10⁻² mbar bis 1x10⁻³ mbar in dem Reaktor (1) erreicht wird.

3. Verfahren zum Nitrieren von Metallegierungen nach Anspruch 1, **dadurch gekennzeichnet, daß** das verwendete Edelgas Argon ist.

4. Verfahren zum Nitrieren von Metallegierungen nach Anspruch 1, **dadurch gekennzeichnet, daß** die elektrischen Bogenentladungseinheiten (3) mit einem Strom von 70 Ampere aktiviert werden.

5. Verfahren zum Nitrieren von Metallegierungen nach Anspruch 1, **dadurch gekennzeichnet, daß** der Träger (5) zwischen -400 und -600 Volt polarisiert wird, die bei 20 bis 30 KHz pulsieren.

6. Verfahren zum Nitrieren von Metallegierungen nach Anspruch 1, **dadurch gekennzeichnet, daß** das Verhältnis zwischen dem Edelgas und dem in den Reaktor (1) eingeleiteten Stickstoff zu gleichen Teilen 50/50 beträgt.

7. Verfahren zum Nitrieren von Metallegierungen nach Anspruch 1, **dadurch gekennzeichnet, daß** Wasserstoff zusammen mit dem Edelgas eingeleitet wird.

8. Vorrichtung zum Ausführen des Verfahrens zum Nitrieren von Metallegierungen nach Anspruch 1, bestehend aus einem geerdeten Reaktor (1), in dem die zu nitrierenden Teile (2) auf einem Träger (5) angeordnet werden, der auf einem pulsierenden Negativpotential errichtet ist, wobei der Reaktor (1) elektrische Bogenentladungseinheiten (3), eine Wärmequelle (4), eine Auffangelektrode (6), die von dem Reaktor (1) elektrisch isoliert ist, einen Gaseinlaß (7) und ein Vakuumsystem (8) umfaßt, **dadurch gekennzeichnet, daß** die Spulen (6.1) zum Konzentrieren des elektrischen Feldes, die geerdet oder mit einem Negativpotential verbunden sind, um die Auffangelektrode (6) herum angeordnet sind.

## Revendications

1. Procédé de nitruration d'alliages métalliques, contenus dans un réacteur mis à la masse (1) muni de bobines (6, 1) destinées à concentrer un champ électrique et mises à la masse également, ou reliées à un potentiel négatif et placées autour d'un collecteur d'électrons (6) électriquement isolé dudit réacteur (1), dans lequel, dans ledit réacteur, les pièces (2) à nitrurer sont placées sur un support (5) établi à un potentiel négatif pulsé, ledit réacteur (1) comprenant des unités de décharge d'arc électrique (3), une source de chaleur (4), une admission de gaz (7) et un système de vide (8), **caractérisé en ce que** ledit procédé comprend au moins les étapes suivantes :
la formation d'un vide important dans ledit réacteur (1), avec une pression non supérieure à 5x10⁻⁶ mbar,
la réalisation d'un chauffage thermique préalable dudit réacteur (1) à l'aide de ladite source de chaleur (4), jusqu'à ce qu'une température non supérieure à 200 °C soit atteinte,
le chauffage desdites pièces (2) en produisant un gaz noble et en effectuant un bombardement, au cours duquel au moins une unité de décharge d'arc électrique (3) est activée avec un courant de l'ordre de 70 à 90 ampères, ledit collecteur d'électrons (6) est polarisé avec une tension continue de l'ordre de +10 à +50 volts, et ledit support (5) est polarisé avec une tension continue de l'ordre de -400 à -800 volts, lesdites pièces (2) étant chauffées à une température de l'ordre de 300 °C à 600 °C,
l'activation de toutes les unités de décharge d'arc électrique (3) entre un courant de 50 et 90 ampères, et la polarisation dudit support (5) à une tenson continue pulsée de l'ordre de -300 à -700 volts, et
l'injection d'azote dans ledit réacteur (1) jusqu'à ce que la proportion entre ledit gaz noble et l'azote soit égale à au moins 10 % d'azote, et la pression à l'intérieur dudit réacteur (1) soit comprise entre 1x10⁻³ et 8x10⁻³ bar.

2. Procédé de nitruration d'alliages métalliques selon la revendication 1, **caractérisé en ce que**, à ladite étape de chauffage desdites pièces (2), ledit gaz noble est introduit jusqu'à atteindre une pression à l'intérieur dudit réacteur (1) de l'ordre de 1x10⁻² mbar à 1x10⁻³ mbar.

3. Procédé de nitruration d'alliages métalliques selon la revendication 1, **caractérisé en ce que** ledit gaz noble utilisé est de l'argon.

4. Procédé de nitruration d'alliages métalliques selon la revendication 1, **caractérisé en ce que** lesdites unités de décharge d'arc électrique (3) sont activées avec un courant de 70 ampères.

5. Procédé de nitruration d'alliages métalliques selon la revendication 1, **caractérisé en ce que** ledit support (5) est polarisé entre -400 et -600 volts pulsés à 20/30 KHz.

6. Procédé de nitruration d'alliages métalliques selon la revendication 1, **caractérisé en ce que** ladite proportion entre ledit gaz noble et l'azote qui sont introduits dans ledit réacteur (1) est à parts égales de 50/50.

7. Procédé de nitruration d'alliages métalliques selon la revendication 1, **caractérisé en ce que** de l'hydrogène est introduit avec ledit gaz noble.

8. Dispositif d'exécution du procédé de nitruration d'alliages métalliques selon la revendication 1, composé d'un réacteur mis à la masse (1) dans lequel les pièces (2) à nitrurer sont placées sur un support (5) établi à un potentiel négatif pulsé, ledit réacteur (1) comprenant des unités de décharge d'arc électrique (3), une source de chaleur (4), un collecteur d'électrons (6) électriquement isolé dudit réacteur (1), une admission de gaz (7), et un système de vide (8), **caractérisé en ce que** lesdites bobines (6, 1) destinées à concentrer le champ électrique et qui sont mises à la masse, ou reliées à un potentiel négatif, sont placées autour dudit collecteur d'électrons (6).
